Europäisches Patentamt

European Patent Office

Office européen des brevets

(11) Publication number: **0 085 436**
**B1**

(12) **EUROPEAN PATENT SPECIFICATION**

(45) Date of publication of patent specification: **26.04.89**

(51) Int. Cl.⁴: **G 11 C 8/00, G 11 C 11/40**

(21) Application number: **83101022.8**

(22) Date of filing: **03.02.83**

(54) **Buffer circuits.**

(30) Priority: **03.02.82 JP 16121/82**

(43) Date of publication of application:
**10.08.83 Bulletin 83/32**

(45) Publication of the grant of the patent:
**26.04.89 Bulletin 89/17**

(84) Designated Contracting States:
**DE FR GB**

(56) References cited:
**EP-A-0 036 743**

**IEEE INTERNATIONAL SOLID-STATE CIRCUITS
CONFERENCE ISSCC 1979, DIGEST OF
TECHNICAL PAPERS, 15th February 1979, IEEE,
New York, US; J.M. LEE et al.: "Dynamic
memories: THPM 12.2: A 80ns 5V-only
dynamic RAM"**

(73) Proprietor: **NEC CORPORATION
33-1, Shiba 5-chome, Minato-ku
Tokyo 108 (JP)**

(72) Inventor: **Hiroaki, Ikeda
c/o Nippon Electric Co., Ltd. 33-1, Shiba
Gochome
Minato-ku Tokyo (JP)**

(74) Representative: **Kehl, Günther, Dipl.-Phys. et al
Patentanwälte HAGEMANN & KEHL Ismaninger
Strasse 108 Postfach 860329
D-8000 München 86 (DE)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

## Description

### Background of the invention

This invention relates to a buffer circuit.

A buffer circuit which produces two output signals having opposite phases (hereinafter termed opposite output signals) in response to a single input signal is constructed to compare the input signal with a predetermined reference voltage signal for obtaining two opposite output signals and is important as a buffer element between an input circuit and an internal circuit in various electronic circuits. As the capacity of memory devices increases and as their operating speed increases, so an address buffer circuit for use with semiconductor memory devices becomes important. For this reason, in the following description, an address buffer circuit utilized in a semiconductor memory device is taken as a typical example.

An address buffer circuit is used in a semiconductor memory device for sending an address selection designation signal to a decoding circuit in accordance with an address input signal, and it is strongly required in such an address buffer circuit that it can accurately judge a designated address and operate at a high sensitivity and high speed, that its power consumption is small, and that the address buffer circuit inclusive of a signal generating circuit can be designed readily and reduced in size for miniaturization of the chip.

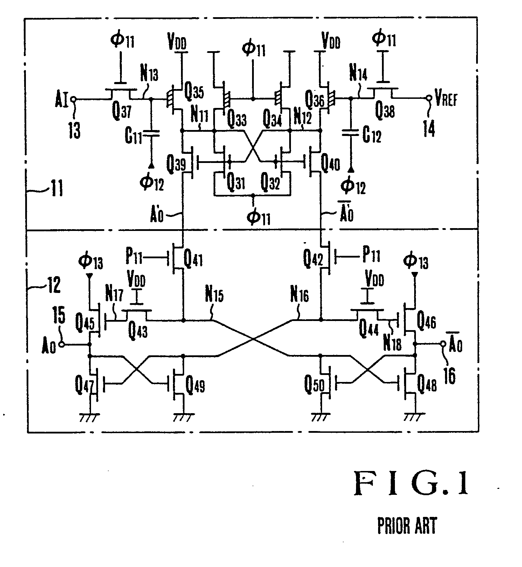

Various circuits have been proposed which meet these requirements (cf EP—A—0 036 743, IEEE International Solid-state Circuits Conference ISSCC 1979, Digest of Technical Papers, 15th February 1979, IEEE, New York, US; J. M. Lee et al.: "Dynamic memories: THPM 12.2: A 80 ns 5V-only dynamic RAM"). Fig. 1 shows one example of the most advanced prior art circuits.

The circuit shown in Fig. 1 comprises a pre-circuit 11 essentially constituted by a flip-flop circuit which is made up of enhancement type field effect transistors (E-FET) $Q_{31}$ and $Q_{32}$ and which compares a single input signal $A_I$ with a predetermined reference voltage signal $V_{REF}$ to produce two opposite pre-output signals $A'_o$ and $\overline{A'_o}$, and a main circuit 12 essentially constituted by another flip-flop circuit made up of E-FETs $Q_{41}$ and $Q_{42}$ acting as a transfer gate which transfers the pre-output signals $A'_o$ and $\overline{A'_o}$ according to a clock signal $P_{11}$, and E-FETs $Q_{47}$ and $Q_{48}$ which produce two opposite output signals $A_o$ and $\overline{A_o}$ when supplied with the pre-output signals $A'_o$ and $\overline{A'_o}$. One of the characteristic features of this circuit lies in that depletion type field effect transistors (D-FET) $Q_{33}$, $Q_{34}$, $Q_{35}$ and $Q_{36}$ are used in the pre-circuit. The operation of this circuit will be outlined as follows.

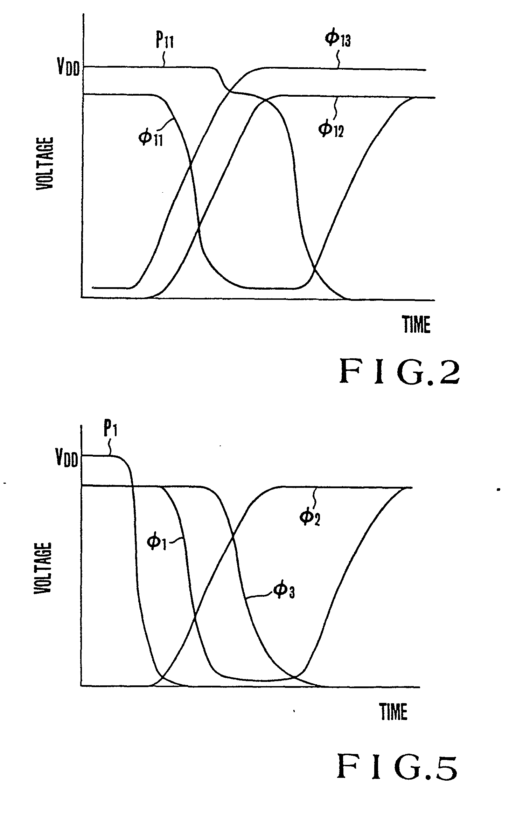

The operation of the pre-circuit will first be described. According to a clock signal $\phi_{11}$, the input signal $A_I$ giving an address input and the reference voltage signal $V_{REF}$ are applied to nodes $N_{13}$ and $N_{14}$ via E-FETs (in the following merely designated as FET except D-FET) $Q_{37}$ and $Q_{38}$. While latching the applied signals by the clock signal $\phi_{11}$, a clock pulse signal $\phi_{12}$ rises to raise the potential of these nodes $N_{13}$ and $N_{14}$ by the action of bootstrap capacitances $C_{11}$ and $C_{12}$. As a consequence, since the capability of D-FETs $Q_{35}$ and $Q_{36}$ are caused to vary by the applied input signal $A_I$ and reference voltage signal $V_{REF}$. Such a change is judged by the flip-flop circuit constituted by FETs $Q_{31}$ and $Q_{32}$ by making a clock signal $\phi_{11}$ low level and the result of judgement appears at nodes $N_{11}$ and $N_{12}$ and is then sent out to the main circuit 12 as the pre-output signals $A'_o$ and $\overline{A'_o}$ via FETs $Q_{39}$ and $Q_{40}$. If the clock signal $\phi_{11}$ is still at a low level even after the judgement of the flip-flop circuit, the D-FETs $Q_{33}$ and $Q_{34}$ on the load side would be turned ON, thereby increasing power consumption. Accordingly, a one shot reverse phase signal as shown in Fig. 2 is used as the clock signal $\phi_{11}$. Since the clock signal $\phi_{11}$ is the one shot reverse phase signal, as the clock signal $\phi_{11}$ rises again, the knots $N_{11}$ and $N_{12}$ will be precharged through D-FETs $Q_{33}$ and $Q_{34}$ again, whereby their address judging information at the nodes $N_{11}$ and $N_{12}$ would be lost, and levels at the nodes $N_{15}$ and $N_{16}$ would be also lost. Thus, the FETs $Q_{41}$ and $Q_{42}$ are provided for the purpose of preventing such loss by separating the nodes $N_{15}$ and $N_{16}$ from the nodes $N_{11}$ and $N_{12}$ kept at high potential levels. The FETs $Q_{41}$ and $Q_{42}$ act as a transfer gate so that pre-output signals $A'_o$ and $\overline{A'_o}$ are applied to nodes $N_{15}$ and $N_{16}$ in the main circuit 12 in accordance with a clock signal $P_{11}$ and then judged by the flip-flop circuit comprising FETs $Q_{47}$ and $Q_{48}$. Judged signals are outputted as output signals $A_o$ and $\overline{A_o}$ from output terminals 15 and 16. The circuit constituted by FETs $Q_{43}$, $Q_{45}$ and $Q_{44}$ and $Q_{46}$ is an output level ensuring circuit which produces an output having the same level as that of a clock signal $\phi_{13}$ by bringing the potential levels of nodes $N_{17}$ and $N_{18}$ up to the levels above the level of the clock signal $\phi_{13}$ by self-boost effect caused by gate-source capacitances of FETs $Q_{45}$ and $Q_{46}$. The FETs $Q_{49}$ and $Q_{50}$ are provided for the purpose of preventing a low level floating in which a low level one of the pre-output signals $A'_o$ and $\overline{A'_o}$ is maintained directly by a high level one of the output signals $A_o$ and $\overline{A_o}$ to turn ON one receiving such high level signal of FETs $Q_{49}$ and $Q_{50}$.

As described above although this prior art circuit is advantageous in that its main circuit 12 is simple and compact in construction, it still involves the following problems. For example, since the output information of the pre-circuit 11 which is transmitted to the nodes $N_{15}$ and $N_{16}$ is directly controlled by the output signals $A_o$ and $\overline{A_o}$ through FETs $Q_{49}$ and $Q_{50}$. When the output signals $A_o$ and $\overline{A_o}$ float the outputs at the nodes $N_{15}$ and $N_{16}$ are lost. Consequently, as shown in Fig. 2, this circuit is inherently sensitive to mutual time spacings between clock signals $\phi_{11}$, $P_{11}$ and $\phi_{13}$. For example, should the clock signal $P_{11}$ become a low level before the clock signal $\phi_{11}$ becomes sufficiently low level, the main circuit would be disconnected from the pre-circuit before the address information is judged by the main circuit. This requires the clock signal generator to ensure the time spacings. Such ensurance can be attained by increasing the time spacing but such expedient prevents high speed operations. Furthermore, as the clock signal $\phi_{13}$ is required not only to directly maintain the output signal level, but also to drive a decoder circuit constituting the load of the address buffer circuit, it becomes necessary to provide a high power clock signal generating circuit having a high level of $V_{DD}$. Such a circuit is complicated and uses large transistors, thereby preventing miniaturization of the chip.

Another prior art circuits also, require a clock signal that rises to the $V_{DD}$ source voltage level at the time of judgement. In addition, there is the problem of time spacing described above. Accordingly, the requirement for clock signal generating circuit is severe, which makes it complex and difficult to design the circuit and prevents miniaturization of the circuit and high speed ooperation thereof.

Summary of the invention

Accordingly, it is an object of this invention to provide an improved buffer circuit in which the requirements for the voltage and time spacing of clock signals necessary for judgement (operation) are not so severe as in the prior art buffer circuit so that the clock signal generating circuit can be designed readily to have a compact size and can operate at a high speed.

According to this invention, there is provided a buffer circuit for producing two output signals of the opposite phases at corresponding output terminals in response to an input signal comprising:

a pre-circuit producing two pre-output signals at corresponding output node thereof in response to said input signal and a reference voltage signal in accordance with a first clock signal;

a main circuit including a flip-flop circuit having two output nodes connected with said output terminals, respectively, for producing said output signal at said output nodes, respectively, in accordance with a second clock signal;

a transfer gate connecting said output nodes of said pre-circuit with said main circuit characterized by said transfer gate connecting said output nodes of said pre-circuit with said output nodes of said flip-flop circuit, said transfer gate circuit being enabled by said pre-output signals and disabled by said output signals of said buffer circuit, said transfer gate circuit comprising a first and a second field effect transistors having source electrodes connected with one and the other of said output nodes of said flip-flop circuit, respectively, and gate electrodes connected with said other and said one of said output nodes of said flip-flop circuit, and a third and fourth field effect transistors having source electrodes connected with drain electrodes of said first and said second field effect transistors, respectively, drain electrodes connected with one and the other of said output nodes of said pre-circuit, respectively, and gate electrodes connected with said gate electrodes of said second and said first field effect transistors, respectively;

an output circuit comprising a first and second field effect transistors having gate electrodes connected with a node between said first and third field effect transistors and a node between said second and said fourth field effect transistors, respectively, source electrodes connected with output terminals, respectively, and drain electrodes connected with a common voltage source, said output circuit amplifying signals presenting at said output nodes of said flip-flop circuit to produce said output signal of said buffer circuit; and

two pre-charging circuits for pre-charging the signals at said output nodes of said flip-flop circuit in accordance with a third clock signal.

Brief description of the drawings

In the accompanying drawings:

Fig. 1 shows a connection diagram of a prior art buffer circuit;

Fig. 2 shows waveforms of clock signal voltages utilized in the circuit shown in Fig. 1;

Fig. 3 is a connection diagram showing one embodiment of the buffer circuit according to this invention;

Fig. 4 shows waveforms of node potentials and clock signal voltages of the circuit shown in Fig. 3; and

Fig. 5 shows waveforms of the clock signal voltages utilized in the circuit shown in Fig. 3.

Description of the preferred embodiment

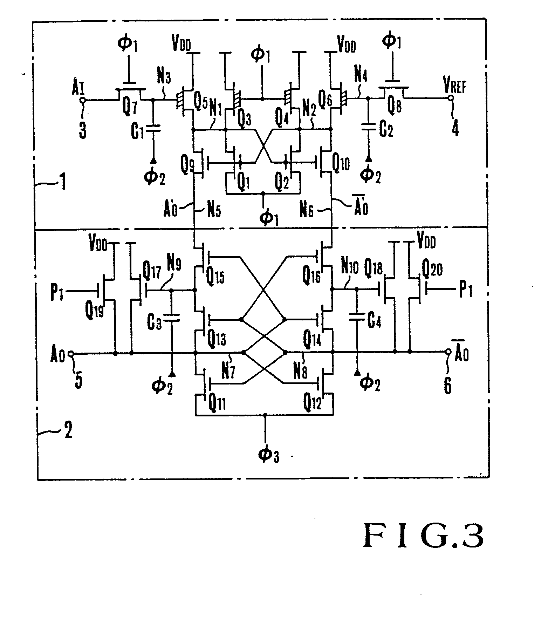

A preferred embodiment of the buffer circuit of this invention illustrated in Fig. 3 is constituted by a pre-circuit 1 which produces two opposite pre-signals $A'_o$ and $\overline{A'}_o$ in response to an address designation input signal $A_I$ impressed upon an input terminal 3 and a reference voltage signal $V_{REF}$ impressed upon a reference voltage terminal 4, and a main circuit 2 supplied with the pre-output signals $A'_o$ and $\overline{A'}_o$ for performing an address judgement to produce two output signals $A_o$ and $\overline{A}_o$ of opposite phases and having predetermined levels.

The pre-circuit 1 has the same construction as that 11 shown in Fig. 1. More particularly, the pre-circuit 1 is constituted by FETs $Q_1$ and $Q_2$ which form a flip-flop circuit cross-connected at nodes $N_1$ and $N_2$, with their source electrode common junction driven by a clock signal $\phi_1$, D-FETs $Q_3$ and $Q_4$ respectively connected between the FETs $Q_1$ and $Q_2$ and a $V_{DD}$ source terminal with their gate electrodes commonly interconnected to be driven by the clock signal $\phi_1$, D-FETs $Q_5$ and $Q_6$ respectively connected between the nodes $N_1$ and $N_2$ and the $V_{DD}$ source terminal, FETs $Q_7$ and $Q_8$ respectively having drain electrodes for forming nodes $N_3$ and $N_4$ together with the gate electrodes of the D-FETs $Q_5$ and $Q_6$, the gate electrode of FETs $Q_7$ and $Q_8$ being driven by the clock signal $\phi_1$ and the source electrodes of the FETs $Q_7$ and $Q_8$ being connected to the input signal terminal 3 and the reference voltage signal terminal 4, respectively, bootstrap capacitors $C_1$ and $C_2$ respectively connected to the nodes $N_3$ and $N_4$ to be driven by a clock signal $\phi_2$, and FETs $Q_9$ and $Q_{10}$ with their drain electrodes connected to the nodes $N_1$ and $N_2$, the gate electrodes commonly connected to the gate electrode of FETs $Q_1$ and $Q_2$ and source electrode acting as output nodes $N_5$ and $N_6$ of the pre-output signals $A'_o$ and $\overline{A'}_o$.

The main circuit 2 is constituted by FETs $Q_{11}$ and $Q_{12}$ cross-connected at nodes $N_7$ and $N_8$ to form a flip-flop circuit, the nodes $N_7$ and $N_8$ forming output terminals 5 and 6 of output signals $A_o$ and $\overline{A_o}$ respectively; FETs $Q_{13}$ and $Q_{14}$ with their source electrodes connected to nodes $N_7$ and $N_8$ and gate electrodes connected to nodes $N_8$ and $N_7$ respectively; FETs $Q_{15}$ and $Q_{16}$ with their source electrodes connected to the drain electrodes of FETs $Q_{13}$ and $Q_{14}$ respectively, drain electrodes connected to source electrodes of FETs $Q_9$ and $Q_{10}$ for forming the nodes $N_5$ and $N_6$ acting as output and input terminals of the pre-output signals $A'_o$ and $\overline{A'}_o$, and the gate electrodes connected to the gate electrodes of FETs $Q_{14}$ and $Q_{13}$ respectively; FETs $Q_{17}$ and $Q_{18}$ with their source electrodes connected to the nodes $N_7$ and $N_8$ respectively, drain electrodes connected to the $V_{DD}$ source terminal, and gate electrodes connected to drain electrodes of FETs $Q_{13}$ and $Q_{14}$ to form nodes $N_9$ and $N_{10}$; bootstrap capacitors $C_3$ and $C_4$ respectively connected to the nodes $N_9$ and $N_{10}$ and driven by a clock signal $\phi_2$; and FETs $Q_{19}$ and $Q_{20}$ with their source electrodes connected to the nodes $N_7$ and $N_8$, drain electrodes connected to the $V_{DD}$ source terminal, and gate electrodes connected to be driven by a clock signal $P_1$. The flip-flop circuit comprised of the FETs $Q_{11}$ and $Q_{12}$ is connected to receive a clock pulse $\phi_3$.

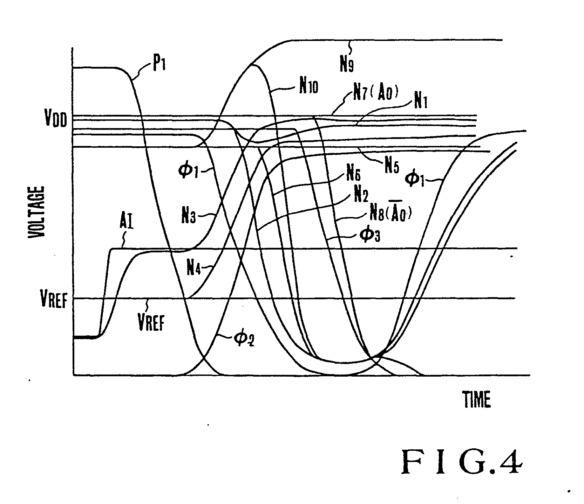

The operation of the embodiment shown in Fig. 3 will now be described with reference to the node potentials and clock signal voltages shown in Fig. 4. For the sake of description, it is assumed that the input signal $A_I$ is at a high level.

Firstly, the level of the clock signal $P_1$ is raised to the level of $V_{DD}$, if necessary, higher than $V_{DD}$ to precharge the output nodes $N_7$ and $N_8$ to a sufficiently high level and the levels of the clock signals $\phi_1$ and $\phi_3$ are raised to a level slightly lower than that of the $V_{DD}$. The input signal $A_I$ at the high level and the reference voltage signal $V_{REF}$ are applied to respective input terminals 3 and 4. Accordingly, both FETs $Q_7$ and $Q_8$ are turned ON to apply the input signal $A_I$ to the node $N_3$ and the reference voltage signal $V_{REF}$ to the node $N_4$. Also the nodes $N_1$ and $N_2$ are precharged to the level of source $V_{DD}$ by the D-FETs $Q_3$ and $Q_4$, and the flip-flop circuit constituted by FETs $Q_1$ and $Q_2$ is in an inoperative state. On the other hand, in the main circuit, FETs $Q_{19}$ and $Q_{20}$ are turned ON to precharge the nodes $N_7$ and $N_8$ to the level of the source voltage $V_{DD}$, with the result that FETs $Q_{13}$ and $Q_{14}$ are turned ON to precharge the nodes $N_9$ and $N_{10}$ to the level of the source voltage $V_{DD}$. Thus, FETs $Q_{15}$ and $Q_{16}$ acting as a transfer gate are turned OFF since nodes $N_5$ and $N_6$ are charged to a high potential through FETs $Q_9$ and $Q_{10}$, whereby the pre-circuit is disconnected from the main circuit.

Then, the level of the clock signal $P_1$ is lowered (to source potential $V_{SS}$ or ground potential), the clock signal $\phi_2$ is raised to a level slightly lower than that of the source voltage $V_{DD}$ and the clock signal $\phi_1$ is lowered to a low level. Accordingly, the nodes $N_3$ and $N_4$ are raised to high potentials by way of the bootstrap capacitors $C_1$ and $C_2$ to make different the capability of D-FETs $Q_5$ and $Q_6$, which changes the potentials of the nodes $N_1$ and $N_2$. The difference is judged by the flip-flop circuit constituted by FETs $Q_1$ and $Q_2$ and the result of judgement appears at the output nodes $N_5$ and $N_6$ of the pre-circuit via FETs $Q_9$ and $Q_{10}$ as the pre-output signals $A'_o$ and $\overline{A'}_o$. On the other hand, in the main circuit, the potentials of nodes $N_9$ and $N_{10}$ are raised to levels higher than the level of the source voltage $V_{DD}$ by the clock signal $\phi_2$ through the medium of the bootstrap capacitors $C_3$ and $C_4$.

Under this state, when the pre-output signals $A'_o$ and $\overline{A_o}$ from the pre-circuit appear at nodes $N_5$ and $N_6$, the FET $Q_{16}$ on the lower level side (since at this time the input signal $A_I$ is at the high level, signal $\overline{A'}_o$ is at the low level) acting as a transfer gate is turned ON to lower the potential of the node $N_{10}$ to a low level. The potential level difference at nodes $N_7$ and $N_8$ is amplified and judged by the flip-flop circuit constituted by FETs $Q_{11}$ and $Q_{12}$ by lowering the level of the clock signal $\phi_3$ from high to low level to produce output signals $A_o$ and $\overline{A_o}$ (in this case, $A_o$ is the low level signal) at the output terminals 5 and 6, respectively, and these output signals are positively fedback to the nodes $N_9$ and $N_{10}$ respectively through FETs $Q_{13}$ and $Q_{14}$. As the output node $N_8$ becomes the low level, the FET $Q_{16}$ automatically turns OFF since the potential of node $N_{10}$ is lowered as a result of turning ON of FET $Q_{14}$ due to the high potential of node $N_7$, whereby the pre-circuit and the main circuit are disconnected again. Consequently, even when the potential of the clock signal $\phi_1$ is increased for the purpose of preventing increase in the power consumption caused by turning ON D-FETs $Q_3$ and $Q_4$ after the judgement effected in the pre-circuit 1, the main circuit 2 will not be influenced. Fig. 5 shows only the clock signals among various waveforms shown in Fig. 4 and the clock signals are depicted to correspond to those shown in Fig. 2.

As described above, the circuit of this embodiment requires 4 clock signals $P_1$, $\phi_1$, $\phi_2$ and $\phi_3$ as shown in Fig. 5 just in the same manner as in the prior art. However, signal $P_1$ is used to precharge the output nodes $N_7$ and $N_8$ to a suitable potential, and may simply be of the same level as that of the source voltage $V_{DD}$ or more, if necessary. Accordingly, different from the clock signal $P_{11}$ necessary for directly driving the transfer gate as in the prior art, the clock signal $P_1$ is not required to have a high level like $V_{DD}$ and a strictly defined time spacing (see Fig. 2). The clock signal $\phi_1$ is a one shot opposite phase signal like the prior art for the purpose of decreasing the power consumption caused by the turning ON of the D-FETs $Q_3$ and $Q_4$ in the pre-circuit after the address judgement. The clock signal $\phi_2$ is used to drive the bootstrap capacitors $C_1$, $C_2$, $C_3$ and $C_4$ for raising the potentials of nodes $N_3$, $N_4$, $N_9$ and $N_{10}$. According to this invention, although the number of the nodes whose potentials are to be increased by 2 as compared to the prior art circuit, the high level is lower than that of the source voltage $V_{DD}$, thus causing no problem. The clock signal $\phi_3$ is used to activate the flip-flop circuit comprising FETs $Q_{11}$ and $Q_{12}$ for judging the address level and its level is changed from a level slightly lower than that of $V_{DD}$ to a much lower level, without requiring any special change. For this reason, in the circuit shown in Fig. 3, it is not necessary to use such the strictly defined strong signal $\phi_{13}$ (shown in Fig. 2) adapted to directly drive a load, which signal is required to have strict time spacings with respect to other signals as in the prior art circuit, and further required to have a higher level than $V_{DD}$ sufficient to self-boot the nodes $N_{17}$ and $N_{18}$ (see Fig. 1) to above $V_{DD}$.

Thus, according to the circuit shown in Fig. 3, among various clock signals, the one necessary for the activation during judgement is not required to have strict voltage and time spacing so that it is not necessary to enlarge the time spacing, to use complicated circuit as well as large capacity transistors. Thus, the clock signal generating circuit can be readily designed, thus ensuring miniaturization and high speed operation of the memory circuit.

Although, in the foregoing embodiment, the buffer circuit has been described by way of an address buffer circuit for a semiconductor memory device, the invention may also be applied to any circuits of a similar type.

As described above, the buffer circuit of this invention is constituted by a pre-circuit producing two pre-output signals having opposite phases in response to an input signal; and a main circuit comprising a transfer gate circuit enabled by the pre-output signal and disabled by the output of the buffer circuit, a latch circuit for latching the pre-output signals, and a flip-flop circuit supplied with the pre-output signals latched by the latch circuit. As a consequence, different from the prior art circuit, it is not necessary to use any strong clock signal required to have high levels equal to the level of the source voltage $V_{DD}$ and strict time spacing during the activation (judging operation) of the circuit, thereby simplifying the design of the clock signal generating circuit, miniaturizing the entire circuit and increasing the operating speed.

## Claims

1. A buffer circuit for producing two output signals ($A_o$, $\overline{A_o}$) of the opposite phases at corresponding output terminals (5, 6) in response to an input signal ($A_I$) comprising:
a pre-circuit (1) producing two pre-output signals ($A'_o$, $\overline{A'_o}$) at a corresponding output node ($N_5$, $N_6$) thereof in response to said input signal ($A_I$) and a reference voltage signal in accordance with a first clock signal ($\phi_1$);
a main circuit (2) including a flip-flop circuit ($Q_{11}$, $Q_{12}$) having two output nodes ($N_7$, $N_8$) connected with said output terminals (5, 6), respectively, for producing said output signal ($A_o$, $\overline{A_o}$) at said output nodes ($N_7$, $N_8$), respectively, in accordance with a second clock signal ($\phi_3$);
a transfer gate ($Q_{13}$, $Q_{14}$, $Q_{15}$, $Q_{16}$) connecting said output nodes ($N_5$, $N_6$) of said pre-circuit (1) with said main circuit (2) characterized by said transfer gate ($Q_{13}$, $Q_{14}$, $Q_{15}$, $Q_{16}$) connecting said output nodes ($N_5$, $N_6$) of said pre-circuit (1) with said output nodes ($N_7$, $N_8$) of said flip-flop circuit ($Q_{11}$, $Q_{12}$), said transfer gate circuit ($Q_{13}$, $Q_{14}$, $Q_{15}$, $Q_{16}$) being enabled by said pre-output signals ($A'_o$, $\overline{A'_o}$) and disabled by said output signals ($A_o$, $\overline{A_o}$) of said buffer circuit, said transfer gate circuit comprising a first ($Q_{13}$) and a second ($Q_{14}$) field effect transistors having source electrodes connected with one ($N_7$) and the other ($N_8$) of said output nodes of said flip-flop circuit ($Q_{11}$, $Q_{12}$), respectively, and gate electrodes connected with said other ($N_8$) and said one ($N_7$) of said output nodes of said flip-flop circuit ($Q_{11}$, $Q_{12}$), and a third ($Q_{15}$) and fourth ($Q_{16}$) field effect transistors having source electrodes connected with drain electrodes of said first ($Q_{13}$) and said second ($Q_{14}$) field effect transistors, respectively, drain electrodes connected with one ($N_5$) and the other ($N_6$) of said output nodes of said pre-circuit (1), respectively, and gate electrodes connected with said gate electrodes of said second ($Q_{14}$) and said first ($Q_{13}$) field effect transistors, respectively;
an output circuit comprising a first ($Q_{17}$) and second ($Q_{18}$) field effect transistors having gate electrodes connected with a node ($N_9$) between said first ($Q_{13}$) and third ($Q_{15}$) field effect transistors and a node ($N_{10}$) between said second ($Q_{14}$) and said fourth ($Q_{16}$) field effect transistors, respectively, source electrodes connected with output terminals (5, 6), respectively, and drain electrodes connected with a common voltage source, said output circuit amplifying signals presenting at said output nodes ($N_7$, $N_8$) of said flip-flop circuit ($Q_{11}$, $Q_{12}$) to produce said output signal ($A_o$, $\overline{A_o}$) of said buffer circuit; and
two pre-charging circuits ($Q_{20}$, $Q_{19}$) for pre-charging the signals at said output nodes ($N_7$, $N_8$) of said flip-flop circuit ($Q_{11}$, $Q_{12}$) in accordance with a third clock signal ($P_1$).

2. A buffer circuit according to claim 1, wherein said output circuits comprises bootstrap capacitors ($C_3$, $C_4$) through which a fourth clock signal ($\phi_2$) is supplied to said gate electrodes of said field effect transistors ($Q_{17}$, $Q_{18}$) thereof.

3. A buffer circuit according to claim 1, wherein said flip-flop circuit ($Q_{11}$, $Q_{12}$) comprises a fifth ($Q_{11}$) and sixth ($Q_{12}$) field effect transistors having common source electrodes to which said second clock signal ($\phi_3$) is supplied, drain electrodes connected with said one ($N_7$) and said other ($N_8$) of said output nodes thereof, respectively, and base electrodes connected with said other ($N_8$) and said one ($N_7$) of said output nodes thereof.

**Patentansprüche**

1. Pufferschaltung zur Erzeugung von zwei gegenphasigen Ausgangssignalen ($A_o$, $\overline{A_o}$) an entsprechenden Ausgangsanschlüssen (5, 6) im Ansprechen auf ein Eingangssignal ($A_I$) mit

einem Vorschaltkreis (1), der zwei Vorausgangssignale ($A'_o$, $\overline{A'_o}$) an seinem entsprechenden Ausgangsknoten ($N_5$, $N_6$) erzeugt im Ansprechen auf das Eingangssignal ($A_I$) und ein Referenzspannungssignal gemäß einem ersten Taktsignal ($\phi_1$);

einem Hauptschaltkreis (2), der ein Flip-Flop ($Q_{11}$, $Q_{12}$) mit zwei Ausgangsknoten ($N_7$, $N_8$) enthält, die jeweils mit den Ausgangsanschlüssen (5, 6) verbunden sind, um das Ausgangssignal ($A_o$, $\overline{A_o}$) jeweils an den Ausgangsknoten ($N_7$, $N_8$) gemäß einem zweiten Taktsignal ($\phi_3$) zu erzeugen; und mit

einem Transfergatter ($Q_{13}$, $Q_{14}$, $Q_{15}$, $Q_{16}$), das die Ausgangsknoten ($N_5$, $N_6$) des Vorschaltkreises (1) mit dem Hauptschaltkreis (2) verbindet,

dadurch gekennzeichnet, daß das Transfergatter ($Q_{13}$, $Q_{14}$, $Q_{15}$, $Q_{16}$) die Ausgangsknoten ($N_5$, $N_6$) des Vorschaltkreises (1) mit den Ausgangsknoten ($N_7$, $N_8$) des Flip-Flops ($Q_{11}$, $Q_{12}$) verbindet, wobei das Transfergatter ($Q_{13}$, $Q_{14}$, $Q_{15}$, $Q_{16}$) durch die Vorausgangssignale ($A'_o$, $\overline{A'_o}$) freigegeben und durch die Ausgangssignale ($A_o$, $\overline{A_o}$) der Pufferschaltung gesperrt wird, welches Transfergatter einen ersten ($Q_{13}$) und einen zweiten ($Q_{14}$) Feldeffekttransistor aufweist, deren SOURCE-Anschlüsse jeweils mit dem einen ($N_7$) und dem anderen ($N_8$) der Ausgangsknoten des Flip-Flops ($Q_{11}$, $Q_{12}$) verbunden sind, deren GATE-Anschlüsse mit dem anderen ($N_8$) und dem einen ($N_7$) der Ausgangsknoten des Flip-Flops ($Q_{11}$, $Q_{12}$) verbunden sind, welches Transfergatter des weiteren einen dritten ($Q_{15}$) und einen vierten ($Q_{16}$) Feldeffekttransistor aufweist, deren SOURCE-Anschlüsse jeweils mit den DRAIN-Anschlüssen des ersten ($Q_{13}$) und des zweiten ($Q_{14}$) Feldeffekttransistors verbunden sind, deren DRAIN-Anschlüsse jeweils mit dem einen ($N_5$) und dem anderen ($N_6$) der Ausgangsknoten des Vorschaltkreises (1) verbunden sind, und deren GATE-Anschlüsse jeweils mit den GATE-Anschlüssen des zweiten ($Q_{14}$) und des ersten ($Q_{13}$) Feldeffekttransistor verbunden sind;

daß ein Ausgangsschaltkreis vorgesehen ist, der einen ersten ($Q_{17}$) und einen zweiten ($Q_{18}$) Feldeffekttransistor aufweist, deren GATE-Anschlüsse jeweils mit einem Knoten ($N_9$) zwischen dem ersten ($Q_{13}$) und dem dritten ($Q_{15}$) Feldeffekttransistor und einem Knoten ($N_{10}$) zwischen dem zweiten ($Q_{14}$) und dem vierten ($Q_{16}$) Feldeffekttransistor verbunden sind, deren SOURCE-Anschlüsse jeweils mit den Ausgangsanschlüssen (5, 6), und deren DRAIN-Anschlüsse mit einer gemeinsamen Spannungsquelle verbunden sind, welcher Ausgangsschaltkreis Signale verstärkt, die an den Ausgangsknoten

($N_7$, $N_8$) des Flip-Flops ($Q_{11}$, $Q_{12}$) zur Verfügung stehen, um das Ausgangssignal ($A_o$, $\overline{A_o}$) der Pufferschaltung zu erzeugen; und

daß zwei Vorladekreise ($Q_{20}$, $Q_{19}$) vorgesehen sind, um die Signale an den Ausgangsknoten ($N_7$, $N_8$) des Flip-Flops ($Q_{11}$, $Q_{12}$) gemäß einem dritten Taktsignal ($P_1$) vorzuladen.

2. Pufferschaltung nach Anspruch 1, bei der die Ausgangsschaltkreise Bootstrap-Kondensatoren ($C_3$, $C_4$) aufweisen, über die ein viertes Taktsignal ($\phi_2$) an die GATE-Anschlüsse ihrer Feldeffekttransistoren ($Q_{17}$, $Q_{18}$) geliefert wird.

3. Pufferschaltung nach Anspruch 1, bei der der Flip-Flop ($Q_{11}$, $Q_{12}$) einen fünften ($Q_{11}$) und einen sechsten ($Q_{12}$) Feldeffekttransistor mit gemeinsamen SOURCE-Anschlüssen aufweist, an die das zweite Taktsignal ($\phi_3$) geliefert wird, und deren DRAIN-Anschlüsse jeweils mit dem einen ($N_7$) und dem andern ($N_8$) der Ausgangsanschlußknoten und deren Basisanschlüsse mit dem anderen ($N_8$) und dem einen ($N_7$) der Ausgangsknoten verbunden sind.

**Revendications**

1. Circuit-tampon pour produire deux signaux de sortie ($A_o$, $\overline{A_o}$) de phases opposées à des bornes de sortie correspondantes (5, 6) en réponse à un signal d'entrée ($A_1$) comprenant:

— un pré-circuit (1) produisant deux signaux de pré-sortie ($A'_o$, $\overline{A'_o}$) à un noeud de sortie correspondant ($N_5$, $N_6$) de celui-ci en réponse au signal d'entrée ($A_1$) et un signal de tension de référence en conformité avec un premier signal d'horloge ($\phi_1$);

— un circuit principal (2) contenant un circuit à bascule ($Q_{11}$, $Q_{12}$) ayant deux noeuds de sortie ($N_7$, $N_8$) connectés aux bornes de sortie (5, 6), respectivement, afin de produire le signal de sortie ($A_o$, $\overline{A_o}$) aux noeuds de sortie ($N_7$, $N_8$), respectivement, en conformité avec un second signal d'horloge ($\phi_3$);

— une grille de transfert ($Q_{13}$, $Q_{14}$, $Q_{15}$, $Q_{16}$) connectant les noeuds de sortie ($N_5$, $N_6$) du pré-circuit (1) au circuit principal (2),

caractérisé en ce que la grille de transfert ($Q_{13}$, $Q_{14}$, $Q_{15}$, $Q_{16}$) connecte les noeuds de sortie ($N_5$, $N_6$) du pré-circuit (1) aux noeuds de sortie ($N_7$, $N_8$) du circuit à bascule ($Q_{11}$, $Q_{12}$), le circuit à grille de transfert ($Q_{13}$, $Q_{14}$, $Q_{15}$, $Q_{16}$), étant validé par les signaux de pré-sortie ($A'_o$, $\overline{A'_o}$) et invalidé par les signaux de sortie ($A_o$, $\overline{A_o}$) du circuit-tampon, le circuit à grille de transfert comprenant des premier ($Q_{13}$) et second ($Q_{14}$) transistors à effet de champ ayant des électrodes de source connectées à l'un ($N_7$) et l'autre ($N_8$) des noeuds de sortie du circuit à bascule ($Q_{11}$, $Q_{12}$), respectivement, et des électrodes de grille connectées à l'autre ($N_8$) et au premier ($N_7$) des noeuds de sortie du circuit à bascule ($Q_{11}$, $Q_{12}$) et des troisième ($Q_{15}$) et quatrième ($Q_{16}$) transistors à effet de champ ayant des électrodes de source connectées aux électrodes de drain des premier ($Q_{13}$) et second ($Q_{14}$) transistors à effet de champ, respectivement, des électrodes de source connectées à l'un ($N_5$) et

l'autre (N_6) des noeuds de sortie du pré-circuit (1), respectivement, et des électrodes de grille sont connectées aux électrodes de grille des seconds (Q_14) et premier (Q_13) transistors à effet de champ, respectivement;

— un circuit de sortie comprend des premier (Q_17) et second (Q_18) transistors à effet de champ ayant des électrodes de grille connectées à un noeud (N_9) entre les premier (Q_13) et troisième (Q_15) transistors à effet de champ et un noeud (N_10) entre les second (Q_14) et quatrième (Q_16) transistors à effet de champ, respectivement, des électrodes de source connectées aux bornes de sortie (5, 6), respectivement, et des électrodes de drain connectées à une source commune de tension, les signaux d'amplification du circuit de sortie étant présents aux noeuds de sortie (N_7, N_8) du circuit à bascule (Q_11, Q_12) pour produire le signal de sortie (A_o, $\overline{A_o}$) du circuit-tampon; et

— deux circuits de pré-charge (Q_20, Q_19) pour précharger les signaux aux noeuds de sortie (N_7, N_8) du circuit à bascule (Q_11, Q_12) en conformité avec un troisième signal d'horloge (P_1).

2. Circuit-tampon selon la revendication 1, dans lequel le circuit de sortie comprend des condensateurs de contre-réaction (C_3, C_4) par l'intermédiaire desquels un quatrième signal d'horloge (φ_2) est fourni aux électrodes de grille de ses transistors à effet de champ (Q_17, Q_18).

3. Circuit-tampon selon la revendication 1, dans lequel le circuit à bascule (Q_11, Q_12) comprend des cinquième (Q_11) et sixième (Q_12) transistors à effet de champ ayant des électrodes de source communes auxquelles le second signal d'horloge (φ_3) est appliqué, des électrodes de drain connectées au premier (N_7) et à l'autre (N_8) de ses noeuds de sortie, respectivement, et des électrodes de base connectées à l'autre (N_8) et au premier (N_7) de ses noeuds de sortie.

# F I G.1

PRIOR ART

F I G.2

F I G.5

2

F I G.3

F I G.4